# EUROPÄISCHE PATENTSCHRIFT

(11) **EP 0 600 119 B1**
(45) Veröffentlichungstag und Bekanntmachung des Hinweises auf die Patenterteilung: **17.03.1999**
(21) Anmeldenummer: 92120539.9
(22) Anmeldetag: 02.12.1992
(51) Int. Cl.: H01H 9/54, H03M 11/10

(54) **Schalteranordnung für Haustechnikinstallationen**
Switch device for technical domestic installation
Dispositif de commutation pour installation technique domestique

(43) Veröffentlichungstag der Anmeldung: 08.06.1994
(73) Patentinhaber: Awag Elektrotechnik AG, 8604 Volketswil (CH)
(72) Erfinder: Heegewald, Steffen, CH-8408 Winterthur (CH)
(74) Vertreter: Blum, Rudolf Emil Ernst

(56) Entgegenhaltungen:
- EP-A- 504 514
- EP-A- 506 626
- DE-A- 2 618 140
- DE-A- 2 816 644
- US-A- 4 202 038

## Beschreibung

Die Erfindung betrifft eine Schalteranordnung für Haustechnikinstallationen nach dem Oberbegriff des Anspruchs 1 sowie eine Haustechnikinstallation mit einer Mehrzahl solcher Schalteranordnungen.

Bisher werden für die verschiedenen Haustechnikinstallationen, wie Licht, Heizung, elektrische Storen, Klimaanlage, in jedem Raum separate Schalter vorgesehen oder gewisse Installationen (Heizung, Klima) werden raumseitig nicht gesteuert, sondern werden nur zentral gesteuert. Es ist dabei einerseits nicht benützerfreundlich und aufwendig, wenn in einem Raum eine Vielzahl von Schaltern installiert werden. Andererseits ist es wünschenswert, wenn Haustechnikinstallationen nicht nur zentral gesteuert werden können, sondern auch eine raumseitige, durch den Benützer zugängliche Steuerung vorhanden ist. Diese sollte aber für den Benützer leicht zugänglich, einfach zu bedienen und ohne grossen Aufwand installierbar sein. Aus der DE-A-26 18 140 ist es bekannt, eine Lampe je nach unterschiedlich langer Betätigung eines Sensorfeldes zu schalten oder zu dimmen.

Der Erfindung liegt deshalb die Aufgabe zugrunde eine Schalteranordnung für Haustechnikinstallationen zu schaffen, bei welcher der Montage- und Installationsaufwand gering ist und welche dennoch eine raumseitige Steuerung verschiedener Haustechnikinstallationen in einer für den Benützer möglichst einfachen und eindeutigen Weise erlaubt.

Diese Aufgabe wird bei einer Schalteranordnung der eingangs genannten Art durch die kennzeichnenden Merkmale des Anspruchs 1 gelöst. Ferner wird die Aufgabe durch eine Haustechnikinstallation gemäss Anspruch 8 gelöst.

Durch die erfindungsgemässe Schalteranordnung können zwei Verbraucher unabhängig voneinander mit nur einem Betätigungselement geschaltet werden, z.B. die Raumbeleuchtung und die Raumheizung. Dabei tritt für den Benützer nur ein Betätigungselement in Erscheinung und es wird nur eine Installationsöffnung benötigt. Durch die optische Anzeige ist klar ersichtlich, welcher Schaltzustand, EIN oder AUS, aktiviert ist.

Vorzugsweise wird die Schaltanordnung zusammen mit einer Heizungsanlage mit separat aktivierbaren bzw. deaktivierbaren Raumheizkörpern verwendet. Die Schaltanordnung schaltet dabei bei kurzer Betätigung des Betätigungselementes die Beleuchtung im Raum in für den Benützer herkömmlicher Weise. Bei langer Betätigung des Betätigungselementes kann der Benützer mit der selben Schaltanordnung die Raumheizung ein- bzw. ausschalten. Ueber den Schaltzustand der Raumheizung wird er dabei von der optischen Anzeige informiert.

Im folgenden werden Ausführungsbeispiele der Erfindung anhand der Zeichnungen näher erläutert. Dabei zeigt
Figur 1 eine schematische Darstellung der Schalteranordnung,
Figur 2 ein Diagramm zur Erläuterung der Schalterbetätigung;
Figur 3 eine schematische Darstellung einer Haustechnikinstallation mit einer Zentralsteuerung und mehreren erfindungsgemässen Schalteranordnungen; und
Figuren 4a, 4b eine Seiten- bzw. eine Frontalansicht einer Schalteranordnung.

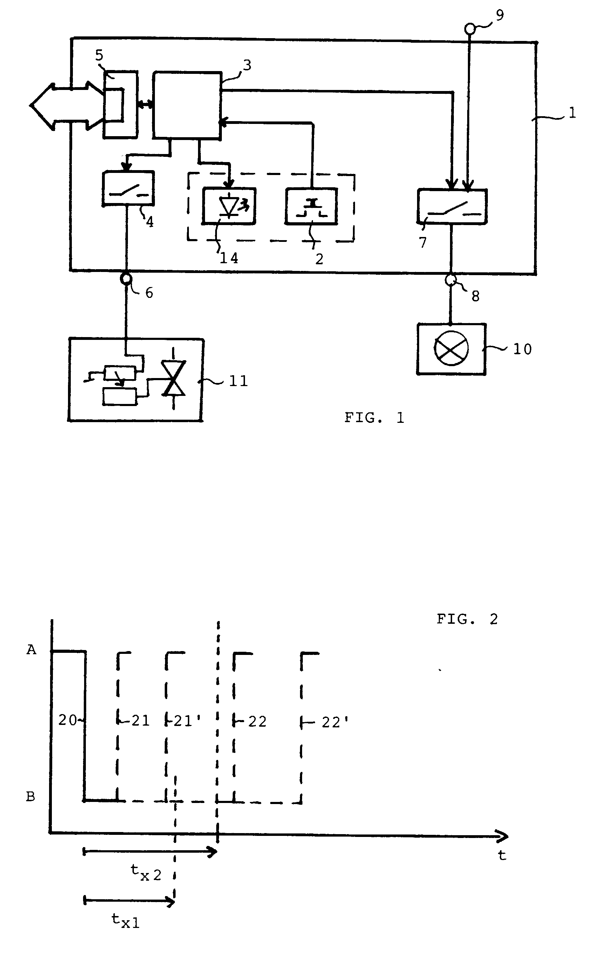

Figur 1 zeigt das Blockschaltbild einer Ausführungsform der erfindungsgemässen Schalteranordnung 1. Diese weist ein Betätigungselement auf, welches in Figur 1 schematisch als Taster 2 dargestellt ist. Eine Betätigung des Tasters 2 gibt einen Impuls an eine Steuerschaltung 3 ab. Die Steuerschaltung 3 steuert einerseits einen Schalter 7. Dieser Schalter 7 kann z.B. als elektronischer Schalter für Netzspannung ausgestaltet sein. An diesem Schalter, dessen Schaltausgang mit 8 bezeichnet ist, ist in diesem Fall ein Netzspannungsverbraucher, z.B. eine Raumbeleuchtung 10 angeschlossen. Die Steuerschaltung 3 steuert ferner in Abhängigkeit von der Betätigung des Tasters 2 einen weiteren Schalter 4. Dieser kann z.B. als Niederspannungsschalter ausgeführt sein. Ueber den entsprechenden Schalterausgang 6 kann ein Niederspannungsverbraucher 11 geschaltet werden, z.B. das Ventil eines Raumheizkörpers. Die Schalteranordnung 1 weist ferner eine optische Anzeige 14 auf, welche ebenfalls von der Steuerschaltung 3 aktiviert wird. Die optische Anzeige 14 kann, wie in Figur 1 angedeutet, in den Taster 2 integriert sein. Bevorzugt ist es ferner, wenn zusätzlich zu der Steuerschaltung 3 eine Schnittstellenschaltung 5 vorgesehen ist, durch welche die Kommunikation mit einem zentralen Steuergerät erfolgen kann, wie später noch beschrieben werden wird. Ferner ist in Figur ein Steuereingang 9 gezeigt, über den weitere Lichtschalter des Raumes auf den elektronischen Schalter 7 einwirken können, damit die Lampe 10 auch von weiteren Lichtschaltern her schaltbar ist. Die Funktion der Schalteranordnung 1 kann anhand der Figur 2 näher erläutert werden.

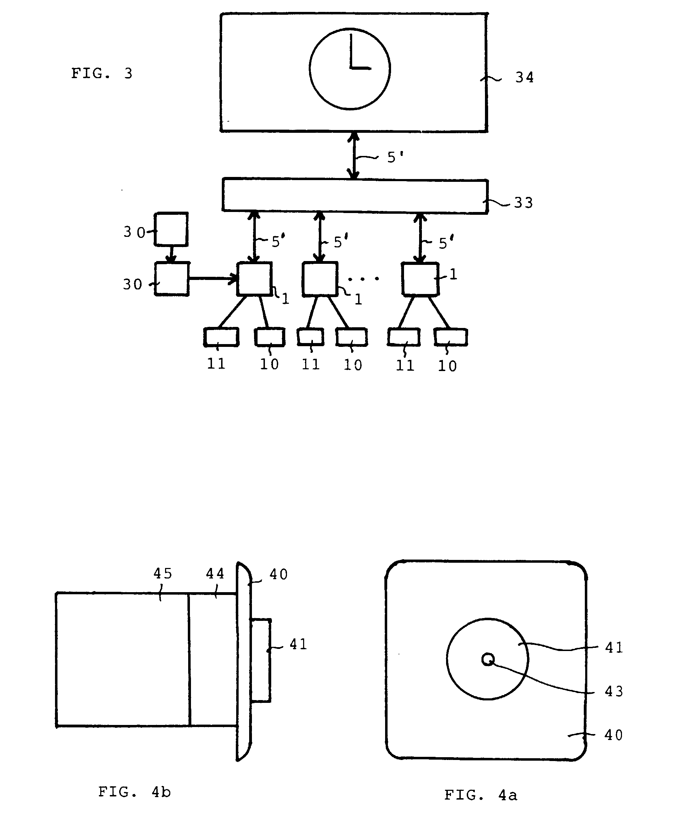

Figur 2 zeigt über der Zeitachse t die Stellung des Tasters 2. Die obere Position A soll dabei die Ruhestellung des Tasters zeigen. Die untere Stellung B stellt die gedrückte Stellung des Tasters 2 dar, wenn dieser also durch den Benützer der Schalteranordnung gedrückt wird. Beim Drücken des Tasters 2, was die fallende Flanke 20 bewirkt, beginnt eine Zeit tₓ₁ zu laufen, welche von der Steuerschaltung 3 bestimmt wird. Wird der Schalter innerhalb der Zeit tₓ₁ , welche z.B. eine Sekunde betragen kann, wieder losgelassen, was durch die steigenden Flanken 21 oder 21' symbolisiert wird, so schaltet die Steuerschaltung aufgrund dieser steigenden Flanke jeweils den Schalter 7 von der einen Schaltstellung in die andere Schaltstellung. Durch die kurzzeitige Betätigung des Tasters 2, wobei unter kurzzeitig eben die Betätigung innerhalb des Zeitfensters tₓ₁ gemeint ist, wird also die Raumbeleuchtung 10 eingeschaltet bzw. ausgeschaltet. Die Schalteranordnung 1, welche vorzugsweise, wie nachfolgend noch gezeigt wird, in einem normalen Lichtschaltergehäuse untergebracht ist, bewirkt also bei kurzzeitiger Betätigung des Tasters 2 die Ein- und Ausschaltung der Raumbeleuchtung auf herkömmliche Weise. Diese Funktion der Schalteranordnung unterscheidet sich für den Benützer nicht von einer normalen Lichtschalterfunktion. Wird der Taster durch den Benützer nach dem Drücken erst nach Ablauf der Zeit tₓ₂ losgelassen, so ergeben sich die steigenden Flanken 22 oder bei noch späterem Loslassen, die steigende Flanke 22'. In diesem Falle, d.h. bei Ueberschreiten der Zeit tₓ₂ , betätigt die Steuerschaltung nicht den Schalter 7, sondern den zweiten Schalter 4. Bei Betätigung während einer Zeitdauer zwischen den Zeiten tₓ₁ und tₓ₂ wird bei diesem Beispiel keine Funktion ausgeführt. Es kann anstelle von tₓ₁ und tₓ₂ auch nur eine Zeit tₓ vorgesehen sein, welche die Unterscheidung zwischen den beiden Funktionen des Schalters bewirkt. Mit diesem zweiten Schalter 4 wird nun ein anderer Verbraucher als die Raumbeleuchtung geschaltet. In Figur 1 ist dabei als bevorzugtes Beispiel das Thermostatventil eines Raumheizungskörpers dargestellt, welches elektrisch beeinflussbar ist. Dabei ist in Figur 1 ein solches Ventil schematisch dargestellt, welches einerseits von einem temperaturabhängigen Fühlerelement in Abhängigkeit von der jeweiligen Raumtemperatur und einer Sollwertvorgabe eingeschaltet oder ausgeschaltet wird. Solche Regelventile an Raumheizkörpern sind bekannt und weit verbreitet. Bekannt ist dabei auch die in Figur 1 schematisch angedeutete Ausführungsform, bei welcher das Fühlerelement durch einen Heizwiderstand beheizt werden kann, so dass durch das Anlegen einer Spannung an den Heizwiderstand das Fühlerelement respektive das Ventil beeinflusst werden kann, um die Temperatur des Raumes abzusenken. Der Schalter 4 dient nun im gezeigten Beispiel zum Anlegen einer elektrischen Spannung an den Heizwiderstand. Mit anderen Worten, durch längere Betätigung des Tasters 2 kann über den Schalter 4 die Solltemperatur respektive die Raumtemperatur abgesenkt werden. Vereinfachend soll dieses Absenken der Raumtemperatur nachfolgend als Abschalten der Heizung bezeichnet werden. Zusammen mit dem Schalter 4 wird von der Steuerschaltung 3 ferner die optische Anzeige 14 der Schalteranordnung betätigt. Dies kann so erfolgen, dass bei eingeschalteter Heizung 11 die Anzeige 14 beleuchtet ist und bei abgeschalteter Heizung 11 die Anzeige 14 erlischt. Für den Benützer präsentiert sich die Schalteranordnung 1 vorzugsweise wie ein normaler Tastenschalter für die Raumbeleuchtung. Bei normaler, kurzzeitiger Betätigung wird auch nur auf gewohnte Weise die Raumbeleuchtung geschaltet. Der Benützer hat aber als weitere Möglichkeit durch länger dauernde Betätigung des Tasters 2 die Möglichkeit, einen weiteren Verbraucher im Raum zu schalten. Der Benützer kann also mit derselben Schalteranordnung 1 und dabei mit derselben Taste 2 zwei verschiedene Verbraucher unabhängig voneinander schalten. Bevorzugterweise wird die Schalteranordnung wie gezeigt als Schalter für die Raumbeleuchtung und für einen Raumheizkörper verwendet. Der Benützer hat dabei die Möglichkeit, beim Verlassen des Raumes den Raumheizkörper abzuschalten, um Energie zu sparen. Anstelle eines Raumheizkörpers 11 könnte aber durch den Schalter 4, welcher natürlich nicht ein Niederspannungsschalter zu sein braucht, sondern welcher ebenfalls ein Netzspannungsschalter sein kann, eine Klimaanlage eingschaltet bzw. ausgeschaltet werden oder es könnte ein elektrischer Storen hochgefahren oder heruntergefahren werden oder es kann eine Steckdose geschaltet werden oder eine Zentral funktion für diverse Verbraucher ausgelöst werden, z.B. kann das Licht in Grossraumbüros für sämtliche Leuchtgruppen zentral geschaltet werden. Es kann auch eine Zufallsschaltung für das Licht aktiviert werden, um die Anwesenheit von Bewohnern zwecks Einbruchsschutz vorzutäuschen, oder es kann ein Alarm ausgelöst werden. Vorteilhaft ist, wie gesagt, dass die Betätigung dieser verschiedenen Verbraucher mittels nur eines Tasters erfolgt. Benötigt wird daher im Raum auch nur eine Installationsöffnung für die Schalteranordnung und der Benützer wird nicht durch mehrere Schalter verwirrt. Figur 3 zeigt schematisch eine Heizungssteuerung für mehrere Räume, wobei in jedem Raum eine Schalteranordnung 1 und steuerbare Raumheizkörper 11 angeordnet sind. Bei der in Figur 3 gezeigten Ausführungsform ist für die Heizungsanlage eine zentrale Schaltuhr 34 vorgesehen, welche die eigentliche Heizung steuert. Von der Schaltuhr 34 besteht über eine Kommunikationsleitung, z.B. eine Zweidrahtleitung oder eine Busleitung, und über eine Interface-Schaltung 33 eine Verbindung zu den einzelnen Schalteranordnungen 1. Dadurch ist es möglich, dass die einzelnen Heizungen 11 einerseits zentral durch die Schaltuhr gesteuert werden, indem die Schaltuhr über die Interface-Schaltung 33 und die Kommunikationsleitungen jeweils auf die Steuerschaltung 3 der einzelnen Schalteranordnung 1 einwirkt, um die Heizung im Raum einzuschalten oder auszuschalten. Diese Ein/Ausschaltung erfolgt auf herkömmliche Weise, z.B. schaltuhrgesteuert, kann aber auch von einem übergeordneten Leitsystem gesteuert werden. Daneben besteht die geschilderte Möglichkeit für jeden Benutzer, mittels der Schalteranordnung 1 individuell die Raumheizung ein- und auszuschalten. In der Regel wird aber die Schaltzentrale 34 Priorität besitzen. Sie kann also den individuellen Befehl mindestens zeitweise überlagern und die Heizung unabhängig von der an der Schalteranordnung 1 gewählten Stellung bedienen. Dies z.B. am Morgen, wenn alle Raumheizungen in Betrieb genommen werden oder am Abend, wenn alle Raumheizungen abgestellt werden. In Figur 3 sind ferner weitere konventionelle Lichttaster 30 als Beispiel gezeigt, welche nur den Einfluss auf die Raumbeleuchtung 10 ermöglichen. Diese parallelgeschalteten Lichttaster können in beliebiger Anzahl ebenfalls über die Schalteranordnung 1 auf die Raumbeleuchtung 10 einwirken, wie in Figur 1 mit dem Eingang 9 angedeutet. Die Schaltuhr 34 bietet die üblichen Möglichkeiten, welche von einer zentralen Schaltuhr ausgeübt werden können. So kann auch durch Handeingriff von der Schaltuhr aus auf einzelne Raumheizungen 11 oder auf Gruppen von Raumheizungen Einfluss genommen werden. Ferner kann eine Anzeige vorgesehen sein, an welcher jeweils der Betriebszustand einzelner Raumheizungen ersichtlich ist. Bei der gezeigten Anordnung kann die Schalteranordnung so wie in Figur 1 dargestellt, ausgeführt sein, d.h. die Steuerschaltung 3 befindet sich jeweils in der Schalteranordnung 1 und kommuniziert mit der Schaltuhr über die Schaltung 5 und die Leitungen 5' unter Zwischenschaltung der Interface-Schaltung 33. Diese Schaltung 33 kann natürlich auch in der Schaltuhr integriert sein. Es ist ferner auch möglich, dass die Steuerschaltung 3 der Schalteranordnung 1 nicht in jedem Raum bei der Schalteranordnung 1 vorgesehen ist, sondern dass die Steuerschaltung 3 jeweils im Interface 33 oder in der Schaltuhr 34 realisiert ist. Natürlich können die Schalteranordnungen 1 jeweils auch unabhängig betrieben werden, ohne die gezeigte Verbindung mit einer zentralen Steuereinrichtung. Die einzelne Schalteranordnung 1 steuert dabei neben der Beleuchtung autonom die Raumheizung 11 oder eine Klimaanlage oder einen Storen.

Figur 4a zeigt eine Vorderansicht einer erfindungsgemässen Schalteranordnung. Diese stellt sich an sich wie ein normaler Lichtschalter dar mit einem Abdeckschild 40 und dem Bedienungselement 41. In dieses Element 41 kann z.B. die Leuchtdiode 43 der Anzeige 14 integriert sein. Diese Anzeige kann natürlich auch auf dem Abdeckschild 40 angeordnet sein und sie kann z.B. auch von einer Glimmlampe gebildet werden.

Die Seitenansicht von Figur 4b zeigt eine bevorzugte Ausgestaltung der Schalteranordnung 1 in modularer Bauweise. Dabei ist ein erstes Modul vorgesehen, welches an das Abdeckschild 40 anschliesst und welches von einem Taster gebildet wird, der über das Betätigungselement 41 betätigbar ist. An den Taster 44 schliesst sich ein weiteres Modul 45 an, welches z.B. den Leistungsschalter 7 für das Licht, die Steuerelektronik 3, die Schaltung 5 und den Schalter 4 enthält. Der Vorteil der Modulbauweise liegt darin, dass auf marktübliche Lichttaster mit dem vertrauten Schaltgefühl aufgebaut werden kann. Die Schalteranordnung ist, wie dargestellt, vorzugsweise als Unterputzinstallation ausgeführt und kann in den üblichen Installationsöffnungen eingebaut werden.

## Patentansprüche

1. Schalteranordnung für Haustechnikinstallationen, die ein Betätigungselement (2,41) aufweist, dadurch gekennzeichnet, dass durch das Betätigungselement (2,4) mindestens zwei Schalter (4,7) mit separaten Schaltausgängen (6,8) zur unabhängigen Schaltung zweier Verbraucher (11,10) unabhängig voneinander betätigbar sind, derart, dass die Wahl und die Betätigung des zu betätigenden Schalters in Abhängigkeit von der Betätigungsdauer des Betätigungselementes erfolgt, und dass die Schalteranordnung eine optische Anzeige (14) aufweist, welche mindestens die Betätigung des einen Schalters (4) anzeigt.

2. Schalteranordnung nach Anspruch 1, dadurch gekennzeichnet, dass der eine Schalter (7) ein Leistungsschalter für Netzspannung ist, der durch eine erste Betätigungsdauer (tₓ₁) des Betätigungselementes (2, 41) schaltbar ist, und dass der zweite Schalter (4) durch eine zweite, längere Betätigungsdauer des Betätigungselementes schaltbar ist und dass dessen Schaltzustand durch die optische Anzeige (14,43) angezeigt wird.

3. Schalteranordnung nach Anspruch 2, dadurch gekennzeichnet, dass die erste Betätigungsdauer ca. 15 Sekunden beträgt.

4. Schalteranordnung nach Anspruch 2 oder 3, dadurch gekennzeichnet, dass der zweite Schalter (4) ein Niederspannungsschalter ist.

5. Schalteranordnung nach einem der Ansprüche 1 bis 4, dadurch gekennzeichnet, dass die Schalteranordnung (1) eine Steuerschaltung (3) für die Schalter aufweist, und eine Kommunikationsschaltung (5) zur Abgabe und zum Empfang von Signalen von einer übergeordneten Steuereinheit (33,34) aufweist.

6. Schalteranordnung nach einem der Ansprüche 1 bis 5, dadurch gekennzeichnet, dass ein Steuereingang (9) für den einen Schalter (7) vorgesehen ist.

7. Schalteranordnung nach einem der Ansprüche 1 bis 6, dadurch gekennzeichnet, dass die Schalteranordnung als Unterputzlichtschalter mit einer modularen Anordnung von Betätigungselement und Schaltern ausgestaltet ist.

8. Haustechnikinstallation mit einer Mehrzahl von jeweils raumseitig angeordneten Schalteranordnungen nach einem der Ansprüche 1 bis 7.

9. Haustechnikinstallation nach Anspruch 8, dadurch gekennzeichnet, dass jeweils der eine Schalter (7) eine Raumbeleuchtung (10) schaltet und der andere Schalter (4) eine das Raumklima beeinflussende raumseitige Haustechnikinstallation, insbesondere einen Raumheizkörper (11) schaltet.

10. Haustechnikinstallation nach Anspruch 8, dadurch gekennzeichnet, dass jeweils der eine Schalter (7) eine Raumbeleuchtung schaltet und der andere Schalter (4) mindestens eine andere Rauminstallation schaltet.

11. Haustechnikinstallation nach einem der
Ansprüche 8 bis 10, dadurch gekennzeichnet, dass eine Zentralsteuereinheit (34) vorgesehen ist, welche mit mindestens einer der Schalteranordnungen (1) in Signalverbindung steht.

## Claims

1. Switching device for technical domestic installation and comprising a command device (2, 41), characterized in that it allows to command independently at least two switches (4, 7) having separate outputs (6, 8) for separately switching two consumption circuits (10, 11), where the choice and the activation of the switch to be activated depend on the duration of the actuation of the command device, and in that the switching device comprises an optical indicator (14) signalling at least the activation of one switch (4).

2. Switching device according to claim 1, characterized in that one switch (7) is a power switch for the mains voltage which can be switched through a first actuation duration (tₓ₁) of the command device (2, 41) that the second switch (4) can be switched through a second, longer actuation duration of the command device, and that its switching state is indicated by the optical indicator (14, 43).

3. Switching device according to claim 2, characterized in that the first actuation duration is about 15 seconds.

4. Switching device according to claim 2 or 3, characterized in that the second switch (4) is a low voltage switch.

5. Switching device according to one among claims 1 to 4, characterized in that it comprises a command circuit (3) for the switches and a communication circuit (5) for exchanging signals with a superimposed command unit (33, 34).

6. Switching device according to one among claims 1 to 5, characterized in that it comprises an input (9) for command signals for one (7) of the switches.

7. Switching device according to one among claims 1 to 6, characterized in that it takes the form of a sunk lighting switch comprising a modular arrangement of switches and command devices.

8. Technical domestic installation with several switching devices according to one of claim 1 to 7 and located in the living precincts.

9. Technical domestic installation according to claim 8, characterized in that one (7) of the switches activates a domestic lighting (10) and the other (4) a technical domestic installation which influences the climate of the precincts, and in particular a precinct heater element (11).

10. Technical domestic installation according to claim 8, characterized in that one (7) of the switches activates a domestic lighting and the other (4) at least one other domestic installation.

11. Technical domestic installation according to one of claims 8 to 10, characterized in that there is provided a central command unit (34) which exchanges signals with at least one of the switching devices (1).

## Revendications

1. Dispositif de commutation pour installation technique, et comportant un organe de commande (2, 41), caractérisé en ce qu'il permet de commander de façon indépendante au moins deux commutateurs (4, 7) ayant des sorties séparées (6, 8) pour commuter séparément deux circuits d'utilisation (10, 11), le choix et l'actionnement du commutateur à activer étant effectué en fonction de la durée de l'actionnement de l'organe de commande, et en ce que le dispositif de commutation comporte un affichage optique (14) signalant au moins l'actionnement d'un des commutateurs.

2. Dispositif de commutation selon la revendication 1, caractérisé en ce qu'un des commutateurs (7) est un commutateur de puissance destiné au voltage du secteur et pouvant être actionné par une première durée d'actionnement (tₓ₁) de l'organe de commande (2, 41), que le second commutateur (4) peut être actionné par une seconde durée d'actionnement de l'organe de commande, et que son mode de fonctionnement est signalé par un affichage optique (14, 43).

3. Dispositif de commutation selon la revendication 2, caractérisé en ce que la première durée d'actionnement est d'environ 15 secondes.

4. Dispositif de commutation selon la revendication 2 ou 3, caractérisé en ce que le second commutateur (4) est un commutateur basse tension.

5. Dispositif de commutation selon une des revendications 1 à 4, caractérisé en ce qu'il comporte un circuit de commande (3) pour les commutateurs ainsi qu'un circuit de communication (5) pour l'échange de signaux avec une unité de commande (33, 34) d'un niveau plus élevé.

6. Dispositif de commutation selon une des revendications 1 à 5, caractérisé en ce qu'il comporte une entrée de commande (9) pour l'un des commutateurs (7).

7. Dispositif de commutation selon une des revendications 1 à 6, caractérisé en ce qu'il est réalisé sous forme d'un commutateur d'éclairage encastré comportant un ensemble modulaire de commutateurs et d'organes de commande.

8. Installation technique domestique avec plusieurs dispositifs de commutation selon une des revendications 1 à 7 disposés dans l'enceinte d'habitation.

9. Installation technique domestique selon la revendication 8, caractérisée en ce que l'un des commutateur (7) commute un éclairage domestique (10) et l'autre (4) une installation technique domestique agissant sur le climat de l'habitation, et en particulier sur un élément de chauffage (11).

10. Installation technique domestique selon la revendication 8, caractérisée en ce que l'un des commutateur (7) commute un éclairage domestique et l'autre (4) au moins une autre installation domestique.

11. Installation technique domestique selon l'une des revendications 8 à 10, caractérisée en ce qu'il est prévu une unité de commande centrale (34) échangeant des signaux avec au moins un des dispositif de commutation.
